# EUROPÄISCHE PATENTSCHRIFT

(11) **EP 0 561 117 B1**
(45) Veröffentlichungstag und Bekanntmachung des Hinweises auf die Patenterteilung: **13.05.1998**
(21) Anmeldenummer: 93100857.7
(22) Anmeldetag: 21.01.1993
(51) Int. Cl.: H04B 1/10, H03G 5/24

(54) **Schaltungsanordnung zur Nachbarkanalerkennung und -unterdrückung in einem Rundfunkempfänger**
Circuit for detection and suppression of adjacent channel interference in a broadcast receiver
Circuit pour détecter et supprimer l'interférence des canaux adjacents dans un récepteur de radiodiffusion

(30) Priorität: 18.03.1992 DE 4208605
(43) Veröffentlichungstag der Anmeldung: 22.09.1993
(73) Patentinhaber: Blaupunkt-Werke GmbH, 31132 Hildesheim (DE)
(72) Erfinder: Vogt, Lothar, Dr., W-3156 Hohenhameln (DE); Bartels, Stefan, Dr., W-3200 Hildesheim (DE); Arnold, Rainer, W-3226 Sibbesse (DE); Schwarz, Detlef, W-3000 Hannover 91 (DE)

(56) Entgegenhaltungen:
- US-A- 3 953 802
- US-A- 4 359 693
- US-A- 4 907 293

## Beschreibung

Die Erfindung betrifft eine Schaltungsanordnung zur Nachbarkanalerkennung und -unterdrückung in einem Rundfunkempfänger nach dem Oberbegriff des Anspruchs 1.

Derartige Schaltungsanordnungen dienen zur Unterdrückung von Störungen, die von Sendern verursacht werden, welche Nachbarkanälen zugeordnet sind und zum Beispiel infolge von Überreichweiten oder großen Frequenzhüben die Wiedergabequalität eines empfangenen Senders beeinträchtigen.

Es ist bekannt, insbesondere bei AM-Empfängern, eine Regelung der ZF-Bandbreite in Abhängigkeit von der Empfangsstärke der Nachbarsender wirken zu lassen, indem man zwei an einen ZF-Kreis angekoppelte, auf je einen Nachbarsender abgestimmte Schwingkreise vorsieht, welche je einen Gleichrichter speisen, deren gleichsinnig in Reihe geschalteten Ausgangsspannungen zur Regelung der ZF-Bandbreite dienen. Die Bandbreitenregelung erfolgt dabei durch Dämpfung bzw. Entdämpfung oder Kopplung oder Verstimmung von ZF-Schwingkreisen.

Aus der US 4, 907, 293 ist eine Schaltungsanordnung bekannt, mit der Interferenzen eines Nachbarkanals bei einem FM-Empfänger unterdrückt werden. Bei dieser Schaltungsanordnung wird das Eingangssignal sowohl einem Breitbandfilter als auch einem parallel geschalteten Schmalbandfilter zugeleitet. In einer nachgeschalteten Erkennungsschaltung wird das jeweilige Signal verstärkt und ein Zwischenfrequenzsignal demoduliert. In einer weiteren Schaltung wird ein Steuersignal gebildet, falls eine Nachbarkanal-Interferenz gefunden wurde.

Der Erfindung liegt die Aufgabe zugrunde, eine Schaltungsanordnung zur Nachbarkanalerkennung und -unterdrückung in einem FM-Rundfunkempfänger zu schaffen, die einen zufriedenstellenden Empfang von durch Nachbarkanäle gestörten Sendern ermöglicht.

Diese Aufgabe wird erfindungsgemäß durch die im kennzeichnenden Teil des Anspruchs 1 angegebenen Maßnahmen gelöst.

Die mit der Erfindung erzielten Vorteile bestehen insbesondere darin, daß die einen geringen schaltungstechnischen Aufwand erfordernde Schaltungsanordnung Nachbarkanalstörungen sicher erkennt sowie durch andere Empfangsstörungen, wie Mehrwegeempfang, Zündstörungen u. ä. Störgrößen bedingte Fehlentscheidungen vermeidet. Zudem bleiben die Funktionen des Empfängers beim Empfang von Verkehrsfunksignalen, RDS-Signalen und Stereo-Signalen erhalten. Ferner erfolgt bei üblichen Schaltungen zur Störimpulsaustastung, bei denen die Störimpulserkennung hinter dem FM-Demodulator erfolgt, keine Beeinträchtigung der Funktion.

Vorteilhafte Ausgestaltungen der Erfindung sind in den Unteransprüchen angegeben. Mit einer Schaltungsanordnung nach Anspruch 2 lassen sich in vorteilhafter Weise die im ZF-Signalweg an Stellen unterschiedlicher Filterbandbreite anstehenden Signalpegel detektieren. In besonders vorteilhafter Weise läßt sich mit einer nach Anspruch 1 bemessene Vergleichsschaltung die Intensität der Nachbarkanalstörungen ermitteln und die zu deren Unterdrückung erforderliche Bandbreite einstellen. Mit einer Schaltungsanordnung nach Anspruch 3 läßt sich die Bandbreite des ZF-Signalweges durch stufenweises Einschalten von vorgegebene Bandbreiten aufweisenden Filtern verändern, wodurch Signalverzerrungen weitgehend vermieden werden.

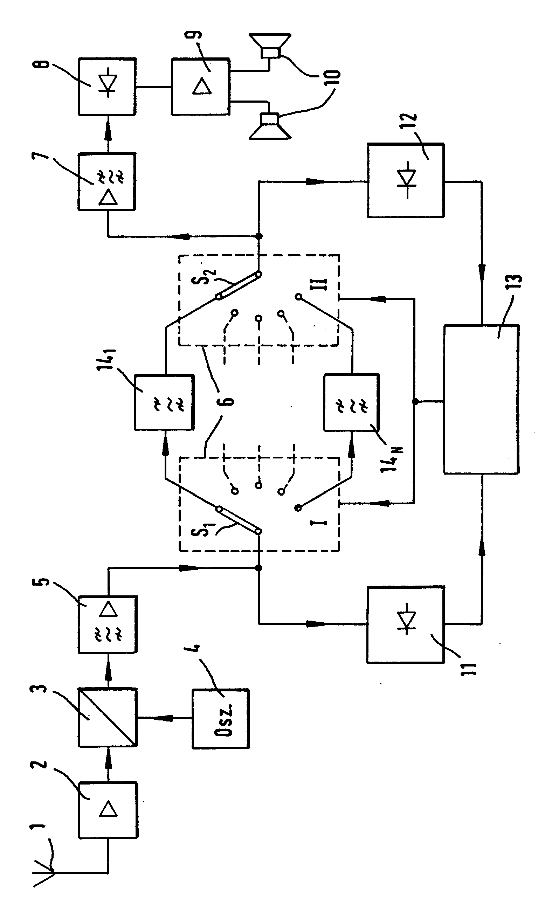

Ein Ausführungsbeispiel der Erfindung ist in der Zeichnung als Blockschaltbild dargestellt und wird im folgenden näher erläutert.

Bei einem vereinfacht dargestellten FM-Empfänger ist der Ausgang einer mit einer Antenne 1 verbundenen HF-Vorstufe 2 mit dem Eingang einer Mischstufe 3 verbunden. Der Ausgang der mit einem Oszillator 4 verbundenen Mischstufe 3 ist mit dem Eingang eines mit einer Verstärkerstufe versehenen ZF-Filters 5 verbunden. Der Ausgang des ZF-Filters 5 ist mit dem ersten Schleifer S₁ eines zwei Schaltebenen I, II aufweisenden elektronisch steuerbaren Stufenschalters 6 verbunden. Der zweite Schleifer S₂ des Stufenschalters 6 ist mit dem Eingang eines ZF-Verstärkers 7 verbunden, dem ein FM-Demodulator 8, ein NF-Verstärker 9 und Lautsprecher 10 nachgeschaltet sind. Auf die Darstellung eines Stereo-Demodulators, eines Verkehrsfunkdecoders und eines RDS-Demodulators wurde verzichtet. Der erste Schleifer S₁ ist mit dem Eingang einer ersten Pegelauswerteschaltung 11 und der zweite Schleifer S₂ mit dem Eingang einer zweiten Pegelauswerteschaltung 12 verbunden. Die Ausgänge der Pegelauswerteschaltungen 11, 12 sind mit den Eingängen einer Vergleichsschaltung 13 verbunden, welche über ihre Ausgangsklemme die Schleifer S₁, S₂ des Stufenschalters 6 synchron steuert. Die einander zugeordneten Schaltkontakte der Schaltebenen I, II sind jeweils über ZF-Filter 14₁ bis 14_{N} verbunden, die abgestufte Bandbreiten aufweisen. Das Filter 14₁, welches von den umschaltbaren Filtern 14₁ bis 14_{N} die größte Bandbreite aufweist, ist derart bemessen, daß bei seinem Einschalten die Bandbreite im ZF-Signalweg am Schleifer S₂ geringer als am Schleifer S₁ ist und die ZF-Bandbreite des gesamten Signalweges der für einen uneingeschränkten Empfang eines FM-Senders üblichen Bandbreite entspricht.

Die an den Schleifern S₁, S₂ anstehenden Signalpegel werden mittels der, beispielsweise Gleichrichter und Tiefpässe aufweisenden, Pegelauswerteschaltung 11, 12 detektiert und der Vergleichsschaltung 13 zugeführt.

Beim Empfang eines durch Nachbarkanalempfang nicht gestörten Senders haben die Pegel am Eingang und Ausgang des Filters 14₁ und damit an den Schleifern S₁, S₂ etwa gleiche Werte. Das Filter 14₁ bleibt somit eingeschaltet. Treten jedoch von einem Nachbarkanalsender stammende Signale in dem vom ZF-Signalweg vorgegebenen Frequenzband auf, so steigt der Signalpegel am ersten Schleifer S₁ stärker an als am zweiten Schleifer S₂. Diese Signalpegel werden in der Vergleichschaltung 13 miteinander verglichen. Liegt der am ersten Schleifer S₁ anliegende Signalpegel um einen vorher definierten Schwellwert über dem am zweiten Schleifer S₂ anliegenden Signalpegel, so wird auf ein Filter 14_{N} mit einer zu diesem Schwellwert festgelegten Bandbreite mittels des Stufenschalters 6 umgeschaltet. Somit ist es möglich, einen infolge Nachbarkanalstörungen empfangsunwürdigen Sender mit einer befriedigenden Empfangsqualität zu empfangen. Dieses ist insbesondere für ein Empfangsbedingungsschwankungen ausgesetztes Autoradio sehr vorteilhaft.

An dieser Stelle sei darauf hingewiesen, daß die in ihrer Bandbreite veränderbare Filteranordnung 6, 14₁ bis 14_{N} auch durch eine Reihenschaltung von Filtern gebildet werden kann, wobei Filter mittels gesteuerter Schaltkontakte überbrückt werden.

## Patentansprüche

1. Schaltungsanordnung zur Nachbarkanalerkennung und -unterdrückung in einem Rundfunkempfänger, insbesondere FM-Empfänger, mit der beim Auftreten von störenden Nachbarkanalsignalen die Bandbreite im ZF-Signalweg verringert wird,
dadurch gekennzeichnet,
daß der Ausgang eines im ZF-Signalweg vorgesehenen ZF-Filters (5) mit dem Eingang einer in ihrer Bandbreite veränderbaren ZF-Filteranordnung (6, 14₁ bis 14_{N}) sowie mit dem Eingang einer ersten Pegelauswerteschaltung (11) verbunden ist, daß der Ausgang der Filteranordnung (6, 14₁ bis 14_{N}) mit dem Eingang einer zweiten Pegelauswerteschaltung (12) verbunden ist, daß die Ausgänge der Pegelauswerteschaltungen (11, 12) mit einer die Bandbreite der ZF-Filteranordnung (6. 14₁ bis 14_{N}) steuernden Vergleichsschaltung (13) verbunden sind, und
daß die Vergleichsschaltung (13) derart bemessen ist, daß sie bei einem vorher definierten Schwellwert, um den der an der ersten Pegelauswerteschaltung (11) anstehende Pegel größer als der an der zweiten Pegelauswerteschaltung (12) anstehende Pegel ist, die Bandbreite des ZF-Signalweges auf einen zu diesem Schwellwert vorher festgelegten Wert einstellt.

2. Schaltungsanordnung zur Nachbarkanalerkennung nach Anspruch 1,
dadurch gekennzeichnet,
daß die Eingänge der Pegelauswerteschaltungen (11, 12) jeweils eine Gleichrichterstufe und einen dieser nachgeschalteten Tiefpaß aufweisen.

3. Schaltungsanordnung zur Nachbarkanalerkennung nach einem der Ansprüche 1 oder 2,
dadurch gekennzeichnet,
daß die in ihrer Bandbreite veränderbare ZF-Filteranordnung (6, 14₁ bis 14_{N}) mindestens zwei Filter (14₁, 14_{N}) unterschiedlicher Bandbreite aufweist, die mittels von der Vergleichsschaltung gesteuerter Schalter (6) in den ZF-Signalweg einschaltbar sind.

4. Schaltungsanordnung zur Nachbarkanalerkennung nach einem der Ansprüche 1 bis 3,
dadurch gekennzeichnet,
daß die Vergleichsschaltung (13) als Logikschaltung ausgebildet ist.

## Claims

1. Circuit arrangement for adjacent channel identification and suppression in a broadcast radio receiver, in particular an FM receiver, by means of which the bandwidth in the IF signal path is reduced when interfering adjacent channel signals occur, characterized in that the output of a first IF filter (5) provided in the IF signal path is connected to the input of a variable bandwidth IF filter arrangement (6, 14₁ to 14_{N}) as well as to the input of a first level evaluation circuit (11), in that the output of the filter arrangement (6, 14₁ to 14_{N}) is connected to the input of a second level evaluation circuit (12), in that the outputs of the level evaluation circuits (11, 12) are connected to a comparison circuit (13) which controls the bandwidth of the IF filter arrangement (6, 14₁ to 14_{N}), and in that the comparison circuit (13) is designed in such a manner that, at a previously defined threshold value by which the level that is present at the first level evaluation circuit (11) is greater than the level that is present at the second level evaluation circuit (12), this comparison circuit (13) sets the bandwidth of the IF signal path to a value previously defined with respect to this threshold value.

2. Circuit arrangement for adjacent channel identification according to Claim 1, characterized in that the inputs of the level evaluation circuits (11, 12) each have a rectifier stage and a low-pass filter connected downstream from it.

3. Circuit arrangement for adjacent channel identification according to one of Claims 1 or 2, characterized in that the variable bandwidth IF filter arrangement (6, 14₁ to 14_{N}) has at least two filters (14₁, 14_{N}) which have different bandwidths and can be connected into the IF signal path by means of switches (6) controlled by the comparison circuit.

4. Circuit arrangement for adjacent channel identification according to one of Claims 1 to 3, characterized in that the comparison circuit (13) is designed as a logic circuit.

## Revendications

1. Circuit pour détecter et supprimer les interférences causées par des canaux adjacents dans un récepteur de radiodiffusion, en particulier pour des récepteurs à modulation de fréquence, circuit avec lequel on réduit la largeur de la bande dans la voie des signaux à fréquence intermédiaire lorsqu'il se produit des signaux parasites provenant des canaux adjacents,
caractérisé en ce que
• la sortie d'un filtre (5) à fréquence intermédiaire, prévu dans la voie des signaux à fréquence intermédiaire, est reliée à l'entrée d'un système de filtrage (6, 14₁ à 14_{N}) à fréquence intermédiaire ,dont la largeur de bande peut être modifiée, ainsi qu'à l'entrée d'un premier circuit d'exploitation de niveaux (11),
• la sortie du système de filtres (6, 14₁ à 14_{N}) est reliée à l'entrée d'un deuxième circuit d'exploitation de niveaux (12),
• les sorties des circuits d'exploitation de niveaux (11, 12) sont reliées à un circuit de comparaison (13) qui commande la largeur de bande du système de filtres à fréquence intermédiaire (6, 14₁ à 14_{N}) et
• le circuit de comparaison (13) est dimensionné de telle sorte qu'il est, dans le cas d'une valeur de seuil définie auparavant, plus grand que le niveau qui se trouve sur le deuxième circuit d'exploitation de niveaux (12), de la valeur des niveaux qui se trouvent sur le premier circuit d'exploitation de niveaux (11), et que largeur de bande de la voie des signaux à fréquence intermédiaire règle sur une valeur déterminée auparavant par rapport à cette valeur de seuil.

2. Circuit pour détecter les interférences causées par des canaux adjacents selon la revendication 1,
caractérisé en ce que
les entrées des circuits d'exploitation de niveaux (11, 12) présentent respectivement un étage redresseur et un filtre passe-bas monté en aval de celui-ci.

3. Circuit pour détecter les interférences causées par des canaux adjacents selon l'une des revendications 1 ou 2,
caractérisé en ce que
le système de filtrage à fréquence intermédiaire (6, 14₁ à 14_{N}), dont la largeur de bande peut être modifiée, présente au moins deux filtres (14 , 14 ) de largeur de bande différente qui peuvent être branchés dans la voie des signaux à fréquence intermédiaire au moyen du commutateur(6) commandé par le circuit de comparaison.

4. Circuit pour détecter les interférences causées par des canaux adjacents selon l'une des revendications 1 à 3,
caractérisé en ce que
le circuit de comparaison (13) est constitué sous la forme d'un circuit logique.
